# EUROPEAN PATENT APPLICATION

(11) **EP 3 118 644 A1**
(43) Date of publication of application: **18.01.2017**
(21) Application number: 16180003.2
(22) Date of filing: 18.07.2016
(51) Int. Cl.: G01R 33/54, G01R 33/561, G01R 33/567, G01R 33/56, G01R 33/563

(54) **REAL-TIME PROSPECTIVE MOTION CORRECTION FOR MRI**

(30) Priority: 13.07.2015 US 201514797784
(71) Applicant: Siemens Medical Solutions USA, Inc., Malvern, PA 19355-1406 (US); Massachusetts General Hospital Corporation, Boston, MA 02114 (US)
(72) Inventor: Bhat, Himanshu, Newton, MA Massachusetts 02459 (US); Cauley, Stephen Farman, Cambridge, MA Massachusetts 02139 (US); Heberlein, Keith Aaron, Charlestown, MA Massachusetts (US); Setsompop, Kawin, Charlestown, MA Massachusetts 02129 (US); Tisdall, Matthew Dylan, Somerville, MA Massachusetts 02143 (US); Van Der Kouwe, Andre Jan Willem, Woburn, MA Massachusetts 01801 (US)
(74) Representative: Patentanwälte Bals & Vogel

(57) **Abstract**

A magnetic resonance (MR) method and system are provided for generating real-time prospective motion-corrected images using fast navigators. The real-time motion correction is achieved by using a 2D EPI navigator that is obtained using a simultaneous multi-slice blipped-CAIPI technique. The navigator parameters such as field of view, voxel size, and matrix size can be selected to facilitate fast acquisition while providing information sufficient to detect rotational motions on the order of several degrees or more and translational motions on the order of several millimeters or more. The total time interval for obtaining and reconstructing navigator data, registering the navigator image, and providing feedback to correct for detected motion, can be on the order of about 100 ms or less. This prospective motion correction can be used with a wide range of MR imaging techniques where the pulse sequences do not have significant intervals of "dead" time.

## Description

### FIELD OF THE DISCLOSURE

The present disclosure relates to a method and a system for generating magnetic resonance (MR) images, and in particular to a method and a system for generating magnetic resonance images with fast prospective motion correction that can be used with a variety of MR imaging techniques.

### BACKGROUND INFORMATION

Magnetic resonance (MR) imaging is a known technology that can produce images of the inside of an examination subject without radiation exposure. In a typical MR imaging procedure, the subject is positioned in a strong, static, homogeneous base magnetic field B0 (having a field strength that is typically between about 0.5 Tesla and 3 Tesla) in an MR apparatus, so that the subject's nuclear spins become oriented along the base magnetic field. Radio-frequency (RF) excitation pulses are directed into the examination subject to excite nuclear magnetic resonances, and subsequent relaxation of the excited nuclear magnetic resonances can generate RF signals. Rapidly switched magnetic gradient fields can be superimposed on the base magnetic field, in various orientations, to provide spatial coding of the RF signal data. The RF signal data can be detected and used to reconstruct images of the examination subject. For example, the acquired RF signal data are typically digitized and stored as complex numerical values in a k-space matrix. An associated MR image can be reconstructed from the k-space matrix populated with such values using a multi-dimensional Fourier transformation.

High-resolution MR imaging typically requires scans with durations measured in minutes. However, such MR imaging procedures can be susceptible to motion of the subject during acquisition of imaging data. Motion effects can appear, e.g., as blurring or ghosting in the image. Even a few millimeters of movement during an MRI procedure can result in motion artifacts that can render the resulting images diagnostically unusable.

One solution to the problem of motion-based image corruption is to discard and reacquire the entire scan, but this implies a substantial cost in time. Alternatively, subject sedation can be used with certain populations (e.g., pediatric clinical subjects) but imposes a risk and is not normally considered ethical for research purposes. A system and method for acquisition of MR images that is insensitive to subject motion is preferable in both research and clinical settings.

Motion-correction systems in magnetic resonance imaging (MRI) can be grouped into two general methods: prospective and retrospective. Retrospective methods use information about the subject's motion, which can be obtained during image data acquisition, to estimate what k-space data would have been measured if the subject had not moved during scanning. Such estimation of 'corrected' k-space data is performed after the imaging data has been obtained (i.e., retrospectively).

Prospective methods typically use motion-tracking data acquired during the scan to follow the subject with the gradient axes of the sequence. Such movement information is used between portions of the data acquisition procedure to correct for the detected motion in the immediately subsequent image data. Prospective approaches rely only on previous measurements to estimate the current position of the patient. However, a prospective system avoids the need to estimate missing k-space data, allowing for direct reconstruction while avoiding possible sources of estimation error in the k-space data.

A variety of prospective systems based on navigator scans have been previously presented. For example, Fourier Transform identities predict that translations in the spatial domain will result in phase shifts in the Fourier domain, and that rotations in the spatial domain will result in rotations in the Fourier domain. Thus, under the assumption that rigid head motion produces identical rigid transformation of both magnitude and phase components of the image data, it is possible to acquire only a small region of k- space as a "navigator" and use this subsampled data to estimate rigid motions.

Echo planar imaging (EPI) techniques can be used to obtain navigator image data for motion correction. EPI can provide a plurality of echoes for obtaining image data, e.g. filling portions of k-space using rapidly varying phase encoding for the echoes, from a single radio frequency (RF) excitation. EPI can thus produce image data much faster than other conventional MR imaging techniques such as gradient recalled echo (GRE) methods. For example, the use of volumetric (3D) EPI navigator sequences to correct for motion effects is described in M.D. Tisdall et al., Volumetric Navigators For Prospective Motion Correction And Selective Reacquisition In Neuroanatomical MRI, Magnetic Resonance in Medicine, 68:389-99 (2012). Navigator-based motion-correction for spectroscopic neuroimaging is described, e.g., in A.T. Hess et al., Real-Time Motion and B0 Corrected Single Voxel Spectroscopy, Magnetic Resonance in Medicine, 66(2):314-323 (2011).

One of the limitations of the EPI navigator approach is the additional time required to collect the navigator images, which typically ranges from about 170 to 300 msec, depending on spatial resolution and coverage. This makes it difficult to insert such navigator sequences into many imaging pulse sequences that do not include significant "dead" time (e.g. 3D fast low angle shot, or FLASH, imaging pulse sequences). The navigator data also must be processed and reconstructed, and the navigator image then registered with prior navigator image(s) and used to update field-of-view and/or scan planes of the MR imaging apparatus, all prior to the next pulse sequence in an imaging procedure. Also, EPI navigators can be susceptible to motion during navigator acquisition, such that longer navigator sequences can limit their accuracy and usefulness.

In another approach, external "markers" can be affixed to a subject during an MR imaging procedure, and motion of such markers can be tracked to determine movement of the subject and thus facilitate prospective motion correction during the imaging procedure. A marker-based approach is described, e.g., in U.S. Patent No. 8,121,361 to Ernst et al. However, such marker-based approaches can require additional and/or specialized equipment, and may be incompatible with certain imaging techniques and/or be less accurate because the markers can be located at some distance from the volume of interest being imaged.

Accordingly, it would be desirable to have a system and method for tracking motion during magnetic resonance imaging procedures that addresses some of the shortcomings described above, including effective motion correction that can be done in real time.

### SUMMARY OF EXEMPLARY EMBODIMENTS

Exemplary embodiments of the present disclosure can provide a magnetic resonance system and method for generating real-time (prospective) motion-corrected images using fast navigators. The real-time motion correction is achieved by using a 2D EPI navigator that can be obtained using a simultaneous multi-slice (SMS) blipped-CAIPI technique.

The navigator parameters such as field of view, voxel size, and matrix size can be selected to facilitate fast acquisition while providing information sufficient to detect rotational motions on the order of several degrees or more and translational motions on the order of several millimeters or more. The total time interval for obtaining and reconstructing navigator data, registering the navigator image, and providing feedback to correct for detected motion, can be on the order of about 100 ms or less.

For example, in accordance with embodiments of the disclosure, a magnetic resonance imaging system can be provided that is configured to obtain and process EPI navigator data, and use the resulting navigator images to determine motion (translation and rotation) of a subject during an imaging procedure. Comparison of the navigator image with one or more previously-obtained navigator images can be used to adapt imaging parameters (e.g., field-of view and/or slice plane orientation) for a subsequent pulse sequence, to provide prospective motion correction and improved image quality for an MR imaging procedure. A navigator image can be obtained and processed within each pulse sequence of any one of a variety of MR imaging procedures. In various embodiments, the MR system can incorporate navigator-based motion correction into imaging sequences such as, but not limited to, T1-weighted, T2-weighted, fluid attenuated inversion recovery (FLAIR), and proton density-weighted (PD-weighted) spin echo or turbo spin echo sequences, gradient echo sequences, functional imaging sequences such as diffusion images, contrast enhanced perfusion (e.g. dynamic susceptibility contrast, or DSC), non-contrast perfusion (e.g. arterial spin labeling, or ASL), blood oxygenation level dependent (BOLD) imaging, and the like.

In embodiments of the disclosure, a field of view (FOV) for the navigator can be, e.g., between about 100 and 500 mm in each direction within a slice plane. The FOV can be between about 20 and 500 mm in the direction perpendicular to the slices. In certain embodiments, the FOV can be between about 200 and 300 mm in each direction within a slice plane. The FOV can also be between about 50 and 150 mm in the direction perpendicular to the slices in further embodiments. For example, in one embodiment, a FOV of about 256 mm x 256 mm x 80 mm can be used for the navigator.

In one embodiment of the disclosure, a spatial resolution between about 3 mm and 10 mm can be used to image the navigator volume. In certain embodiments, a spatial resolution between 5 mm and 8 mm in each principal direction can be used. In one embodiment, a spatial resolution of about 8 mm in each of three principal directions can be used. The spatial resolution can correspond to the size of a voxel image in a particular direction.

A small flip angle, e.g., between 2 degrees and 40 degrees, can be used to facilitate fast acquisition of the multi-slice EPI navigator image data. In certain embodiments, the flip angle can be between about 5 degrees and 20 degrees. In one embodiment, the flip angle can be about 10 degrees.

Embodiments of the present disclosure can obtain the SMS fast navigator data using a blipped controlled aliasing in parallel imaging (blipped-CAIPI) technique. Inter-slice image shifts in the phase encoding direction used with the blipped-CAIPI technique can be between, e.g., FOV/2 and FOV/7.

The number of RF excitations (shots) used to image a navigator volume can be between 1 and 10. In further embodiments, the number of shots used for the multislice excitations during imaging of a navigator volume can be between 1 and 6, or preferably between 2 and 4. The number of SMS shots used for a particular navigator can be based at least in part on the duration of any intervals of "dead" time in a particular pulse sequence of an imaging technique that is being motion-corrected.

In embodiments of the disclosure, between 2 and 12 slices can be excited simultaneously to obtain a navigator image. Various combinations of simultaneous slices and number of shots can be used in further embodiments of the disclosure. For example, image data for a 10-slice navigator can be acquired with 2 shots of 5 slices each, or with 5 shots of 2 slices each, or with a single 10-slice shot. The number of shots used in a particular embodiment can be based on, e.g., the total number of slices desired to image the navigator volume, the size of the navigator volume, the spatial resolution of the navigator image, and the amount of "dead" time in a pulse sequence that the navigator sequence can be inserted into.

In embodiments of the present disclosure, 2D SMS EPI navigator images can be acquired in very short acquisition times, on the order of tens of milliseconds. The navigator image data can be obtained in less than 100 ms in certain embodiments. In further embodiments, the navigator data can be obtained in less than 50 ms, or less than 30 ms.

Embodiments of the disclosure can provide comparison of a navigator image with one or more previously-obtained navigator images correct for subject motion by modifying certain imaging parameters of a subsequent pulse sequence. For example, a conventional 3D prospective acquisition correction (3DPACE) technique or the like can be used to correct for subject motion by updating certain imaging parameters for subsequent pulse sequences based on the navigator image information.

In further exemplary embodiments of the disclosure, an exemplary method for obtaining prospective motion-corrected MR images using fast 2D EPI SMS-based navigators can be provided. Such method can include preparing and initiating any one of a variety of MR imaging procedures by performing a first pulse sequence using an MR imaging system. A 2D EPI SMS navigator sequence can be inserted into the pulse sequence to obtain navigator image data. The navigator image data can be processed and reconstructed, e.g., using an image processing unit of the MR system, to obtain a navigator image.

A next pulse sequence for the imaging procedure can then be performed, and another navigator sequence can be inserted into this pulse sequence. This navigator image data can also be processed and reconstructed to obtain a next navigator image. The processing/reconstruction of each navigator image can be performed, e.g., during the associated pulse sequence in which the navigator image data was obtained.

Each navigator image can be registered with a previous navigator image to determine any relative motion of the subject that has occurred between successive pulse sequences during the imaging procedure. Feedback information can then be provided to the magnetic resonance system to update the field of view and/or scanning planes for the subsequent pulse sequence. Such feedback information can thus be used to adjust imaging parameters for the subsequent pulse sequence to correct the data acquisition for detected motion of the subject between pulse sequences.

After the motion-correction feedback information is provided, another pulse sequence for the imaging procedure with an inserted 2D EPI SMS navigator sequence can again be performed, where this next pulse sequence is based on the motion-correction feedback information. These steps can be repeated until the imaging sequence is completed. The image data can then be processed to obtain a motion-corrected image of the volume or region of interest.

Accordingly, embodiments of the disclosure can provide prospective motion correction that can be used with a wide range of MR imaging techniques, particularly those where the pulse sequences do not have significant intervals of "dead" time.

### BRIEF DESCRIPTION OF THE DRAWINGS

Further objects, features and advantages of the present disclosure will become apparent from the following detailed description taken in conjunction with the accompanying figures showing illustrative embodiments, results and/or features of the exemplary embodiments of the present disclosure, in which:
FIG. 1 schematically illustrates the basic components of a magnetic resonance imaging system constructed and operating in accordance with embodiments of the present disclosure;
FIG. 2 is a flowchart of an exemplary prospective motion-corrected imaging method in accordance with embodiments of the present disclosure.
FIG. 3A is a data plot comparing estimates of rotational motion of two human subjects that were obtained using both a high-resolution 3D FLASH technique and a 2D SMS EPI navigator technique in accordance with exemplary embodiments of the present disclosure;
FIG. 3B is a data plot comparing estimates of translational motion of two human subjects obtained during the same imaging procedures used to obtain the data shown in FIG. 3A;
FIG 4 shows exemplary 2D SMS EPI navigator images acquired in two subjects in accordance with embodiments of the present disclosure;
FIGS. 5A and 5B show motion-corrected and uncorrected magnetization prepared rapid gradient echo (MPRAGE) images, respectively, of a first subject, where the motion correction was performed in accordance with exemplary embodiments of the present disclosure; and
FIGS. 6A and 6B show motion-corrected and uncorrected MPRAGE images, respectively, of a second subject, where the motion correction was performed in accordance with exemplary embodiments of the present disclosure.

Throughout the drawings, the same reference numerals and characters, unless otherwise stated, are used to denote like features, elements, components, or portions of the illustrated embodiments. Similar features may thus be described by the same reference numerals, which indicate to the skilled reader that exchanges of features between different embodiments can be done unless otherwise explicitly stated. Moreover, while the present disclosure will now be described in detail with reference to the figures, it is done so in connection with the illustrative embodiments and is not limited by the particular embodiments illustrated in the figures. It is intended that changes and modifications can be made to the described embodiments without departing from the true scope and spirit of the present disclosure as defined by the appended claims.

### DETAII,ED DESCRIPTION OF EXEMPLARY EMBODIMENTS

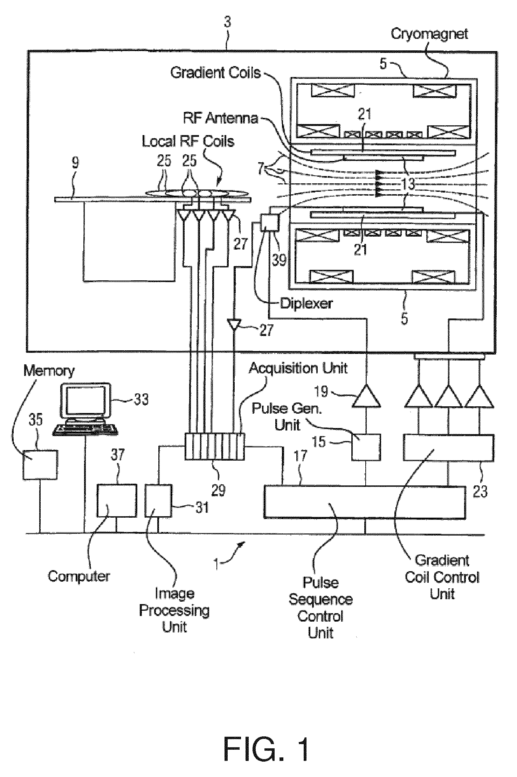

The present disclosure relates to methods and systems for providing real-time prospective motion correction for magnetic resonance imaging using fast volumetric navigators. FIG. 1 schematically shows the design of a magnetic resonance system 1 with certain components in accordance with embodiments of the present disclosure. The MR system 1 is configured, *inter alia,* to provide various magnetic fields tuned to one another as precisely as possible in terms of their temporal and spatial characteristics to facilitate examination of portions of a subject's body using magnetic resonance imaging techniques.

A strong magnet 5 (typically a cryomagnet) having a tunnel-shaped opening is provided in a radio-frequency (RF) shielded measurement chamber 3 to generate a static, strong base (or polarizing) magnetic field 7. The strength of the base magnetic field 7 is typically between 1 Tesla and 3 Tesla, although lower or higher field strengths can be provided in certain embodiments. A body or a body part to be examined (not shown) can be positioned within the substantially homogeneous region of the base magnetic field 7, e.g., provided on a patient bed 9.

Excitation of nuclear spins of certain atoms within the body can be provided via magnetic RF excitation pulses that are radiated using an RF antenna 13, such as a body coil. Other configurations of RF coils or antennas can also be provided in further embodiments, and such configurations may be adapted for particular portions of the subject anatomy to be imaged. The RF excitation pulses are generated by a pulse generation unit 15 that is controlled by a pulse sequence control unit 17. After an amplification by a radio-frequency amplifier 19, the RF pulses are relayed to the RF antenna 13. The exemplary RF system shown in FIG. 1 is a schematic illustration, and particular configurations of the various components may vary from that illustrated in exemplary embodiments of the disclosure. For example, the MR system 1 can include a plurality of pulse generation units 15, a plurality of RF amplifiers 19, and/or a plurality of RF antennas 13 that may have different configurations depending on the body parts being imaged.

The magnetic resonance system 1 further includes gradient coils 21 that can provide directionally and temporally varied magnetic gradient fields for selective excitation and spatial encoding of the RF signals that are emitted and/or received by the RF antenna(s) 13. The gradient coils 21 are typically oriented along the three primary axes (x- y- and z-directions), although other or additional orientations may be used in certain embodiments. Pulsed current supplied to the gradient coils 21 can be controlled by a gradient coil control unit 23 that, like the pulse generation unit 15, is connected with the pulse sequence control unit 27. By controlling the pulsed current supplied to the gradient coils 21, transient gradient magnetic fields in the x-, y-, and z-directions can be superimposed on the static base magnetic field B0. This makes it possible to set and vary, for example, the directions and magnitudes of a slice gradient magnetic field Gs, a phase encode gradient magnetic field Ge, and a read (frequency encode) gradient magnetic field Gr, which can be synchronized with emission and detection of RF pulses. Such interactions between RF pulses and transient magnetic fields can provide spatially selective excitation and spatial encoding of RF signals.

RF signals emitted by the excited nuclear spins can be detected by the RF antenna 13 and/or by local coils 25, amplified by associated radio-frequency preamplifiers 27, and processed further and digitized by an acquisition unit 29. In certain embodiments where a coil 13 (such as, for example, a body coil) can be operated both in transmission mode and in acquisition mode (e.g., it can be used to both emit RF excitation pulses and receive RF signals emitted by nuclear spins), the correct relaying of RF energy is regulated by an upstream transmission-reception diplexer 39.

An image processing unit 31 can generate one or more images based on the RF signals that represent image data. Such images can be presented to a user via an operator console 33 and/or be stored in a memory unit 35. A processor arrangement 37 can be provided in communication with the memory unit 35, and configured to execute computer-executable instructions stored in the memory unit 35 to control various individual system components. For example, the processor arrangement 37 can be configured by programmed instructions to control such components to generate particular sequences of RF pulses and magnetic field variations, process and/or manipulate image data, etc., according to exemplary embodiments of the disclosure described herein.

Embodiments of the present disclosure can provide prospective motion-corrected MR imaging using EPI navigator image data obtained with a simultaneous multi-slice (SMS) technique. Such motion correction can be used, e.g., for imaging of a subject's brain or a portion thereof (or for imaging any other body part that can be assumed to move rigidly). For example, in accordance with embodiments of the disclosure, the gradient coil control unit 23, the pulse generation unit 15, the pulse sequence control unit 27, the image processing unit 31, and the processor arrangement 37 of the MR system 1 shown in FIG. 1 can be configured to obtain and process EPI navigator data, and use the resulting navigator images to determine motion (translation and rotation) of a subject during an imaging procedure. A navigator image can be obtained and processed within each pulse sequence of an imaging procedure, and comparison of the navigator image with one or more previously-obtained navigator images can be used to adapt imaging parameters (e.g., field-of-view and/or slice plane orientation) for a subsequent pulse sequence.

Image data acquisition using the simultaneous acquisition of multiple slices can be very effective because it can directly reduce the amount of time needed to acquire a fixed number of slices. For example, if three imaging slices are acquired per RF excitation (e.g., per 'shot') instead of one, the total acquisition time decreases directly by a factor of three. Additionally, unlike standard parallel imaging techniques, simultaneous multi-slice acquisition methods do not shorten the readout period or omit k-space samples. Therefore, they do not introduce a √R reduction of the signal-to-noise ratio (SNR) (where R is the acceleration factor), as is typically seen with conventional parallel imaging acceleration.

Unaliasing of simultaneously acquired, closely spaced slices can be difficult, leading to a high geometry factor (g-factor) penalty. The g-factor represents a reduction in the effective SNR relating to the ability of a particular RF coil configuration to separate pixels superimposed by aliasing. To avoid such signal impairment for navigator data, which can reduce the accuracy of the motion determined by such navigators, embodiments of the present disclosure obtain the SMS fast navigator data using a blipped controlled aliasing in parallel imaging (blipped-CAIPI) technique. The blipped-CAIPI technique, as applied to spin echo EPI (SE-EPI) and GRE-EPI sequences for diffusion and functional MR imaging of imaging of a large anatomical volume, such as a whole brain, is described, e.g., in K. Setsompop et al., Blipped-Controlled Aliasing in Parallel Imaging (blipped-CAIPI) for Simultaneous Multi-Slice EPI with Reduced g-Factor Penalty, Magnetic Resonance in Medicine, 67(5):1210-1224 (2012).

A blipped-CAIPI technique creates inter-slice image shifts in the phase encoding direction to increase the distance between aliasing pixels. The shift between the slices is induced using sign- and amplitude-modulated slice-select gradient blips simultaneous with the EPI phase encoding blips. This approach can achieve a desired shift between image slice data but avoids an undesired "tilted voxel" blurring artifact that is typically associated with other SMS methods, such as a blipped-wideband approach.

Accordingly, the blipped-CAIPI technique facilitates acquisition of multiple slices simultaneously with higher temporal resolution and improved unaliasing of simultaneously-excited slices. SMS acceleration can be combined with improved unaliasing and certain navigator image parameters to speed up the acquisition of accurate EPI navigators significantly as compared to conventional navigator-based techniques.

In embodiments of the present disclosure, 2D SMS EPI navigator images can be acquired in very short acquisition times, on the order of tens of milliseconds. Such navigators can be obtained using a SMS imaging technique with, for example, between 2 and 12 simultaneously-excited slices per RF excitation (or shot). A small flip angle, e.g., between 2 degrees and 40 degrees, can be used to facilitate fast acquisition of the multi-slice EPI navigator image data. In certain embodiments, the flip angle can be between about 5 degrees and 20 degrees, or about 10 degrees. Such flip angles provide sufficient signal for obtaining the navigator images while facilitating fast acquisition of the multi-slice images having more than one RF excitation.

A field of view (FOV) for the navigator can be, e.g., between about 100 and 500 mm in each direction within a slice plane, and between about 20 and 500 mm in the direction perpendicular to the slices. In certain embodiments, this FOV can be, e.g., between about 200 and 300 mm in each direction within a slice plane. The FOV can also be between about 50 and 150 mm in the direction perpendicular to the slices. For example, in one embodiment, a FOV of about 256x256x80 mm³ can be used for the navigator. Such FOV values can be sufficiently small to facilitate fast acquisition of the navigator image data, and be sufficiently large to provide accurate detection of subject motion (translation and rotation) when registered against other navigator images.

A spatial resolution between about 3 mm and 10 mm can be used. In certain embodiments, a spatial resolution between 5 mm and 8 mm in each principal direction can be used. For example, in one embodiment, a spatial resolution of about 8x8x8 mm³ (e.g., about 8mm resolution, or 8 mm voxel size, in each of three principal directions) can be used. Such exemplary spatial resolutions can provide a balance between navigator detail needed to accurately detect subject movement and both fast and effective reconstruction and unaliasing of the multi-slice navigator image data.

Based on a time needed to acquire the multi-slice image data, and accuracy and resolution of the resulting images, the number of RF excitations (shots) used to image a navigator volume can be between 1 and 10. In further embodiments, the number of shots used for the multislice excitations during imaging of a navigator volume can be between 1 and 6, or preferably between 2 and 4. For example, a smaller number of shots can be used if the navigator sequence is being inserted into an imaging pulse sequence that has very short intervals of "dead" time to reduce the time needed to acquire the navigator image data. A larger number of shots can be used in certain embodiments if the navigator is being inserted into a pulse sequence that has a longer "unused" time interval within a repetition time TR.

Various combinations of simultaneous slices and number of shots can be used in embodiments of the disclosure. For example, if the navigator is made up of 10 slices and 5 slices are acquired simultaneously (SMS5), then 2 shots (RF excitations) can be used to acquire the entire volume. In the same example, if the navigator imaging procedure excites and acquires data for 2 slices simultaneously (SMS2), then it will need 5 shots to acquire the entire volume. Alternatively, this navigator imaging could be achieved by acquiring 10 slices simultaneously (SMS10) with only a single RF excitation. Generally, between 2 and 12 slices can be excited simultaneously to obtain a navigator image. The number of shots used can be based on, e.g., the total number of slices desired to image the navigator volume, the size of the navigator volume, and the spatial resolution of the navigator image.

The number of slices obtained per shot can be selected based on factors such as, e.g., the number of channels in the RF receiving coil being used. The coil characteristics can affect the quality of the image reconstruction in an SMS imaging procedure. For example, with a 64-channel RF receive coil, up to about 12 slices can be excited and imaged simultaneously (SMS 12) while retaining sufficiently good image quality. A 32-channel RF receive coil may limit the simultaneously-excited slices to 8 (SMS8) to avoid reconstructed navigator image degradation. Similarly, a 20-channel RF receive coil may be limited to 4 simultaneously-excited slices (SMS4) to obtain reconstructed navigator images of sufficient quality to accurately detect motion.

For the blipped-CAIPI technique used to acquire navigator image data, a phase encoding shift in the range of FOV/2 to FOV/7 between simultaneously-acquired slices can be used as described, e.g., in Setsompop et al.

A navigator image can be obtained using the exemplary multi-slice parameters and techniques as described herein, and processed within each pulse sequence of an imaging procedure. Comparison of such navigator image with one or more previously-obtained navigator images can be used to adapt certain imaging parameters for a subsequent pulse sequence. For example, a conventional 3D prospective acquisition correction (3DPACE) technique can be used to correct for subject motion by updating certain imaging parameters for subsequent pulse sequences based on the navigator image information. The 3DPACE technique is described, e.g., in Thesen et al., Prospective acquisition correction for head motion with image-based tracking for real-time fMRI, Magnetic Resonance in Medicine, 44(3):457-465 (2000).

The 2D EPI fast navigator described herein can be incorporated into pulse imaging sequences for a variety of MR imaging techniques to provide prospective motion correction and improved image quality. For example, the total time needed to obtain the navigator image data can be less than about 100 ms. In certain embodiments, this total time can be less than 50 ms, or even less than 30 ms. In further embodiments, the steps of obtaining, processing and reconstructing navigator image data, registering the navigator with previous ones, and providing feedback to the MR imaging scanner to update FOV and/or scanning planes for a subsequent pulse sequence, can all be performed in a time interval that is on the order of about 100 ms, as described in the examples below.

Accordingly, the motion correction system and method in accordance with embodiments of the present disclosure can be incorporated in a variety of MR imaging procedures, including those that have little "dead" time during associated pulse imaging sequences that make up these imaging procedures. Magnetic resonance imaging procedures that can be used with embodiments of the present disclosure include, but are not limited to, T1-weighted, T2-weighted, fluid attenuated inversion recovery (FLAIR), and proton density-weighted (PD-weighted) spin echo or turbo spin echo sequences, gradient echo sequences, functional imaging sequences such as diffusion images, contrast enhanced perfusion (e.g. dynamic susceptibility contrast, or DSC), non-contrast perfusion (e.g. arterial spin labeling, or ASL), blood oxygenation level dependent (BOLD) imaging, and the like. Navigator pulse sequences can be inserted into individual ones of the imaging sequences associated with these MR imaging procedures.

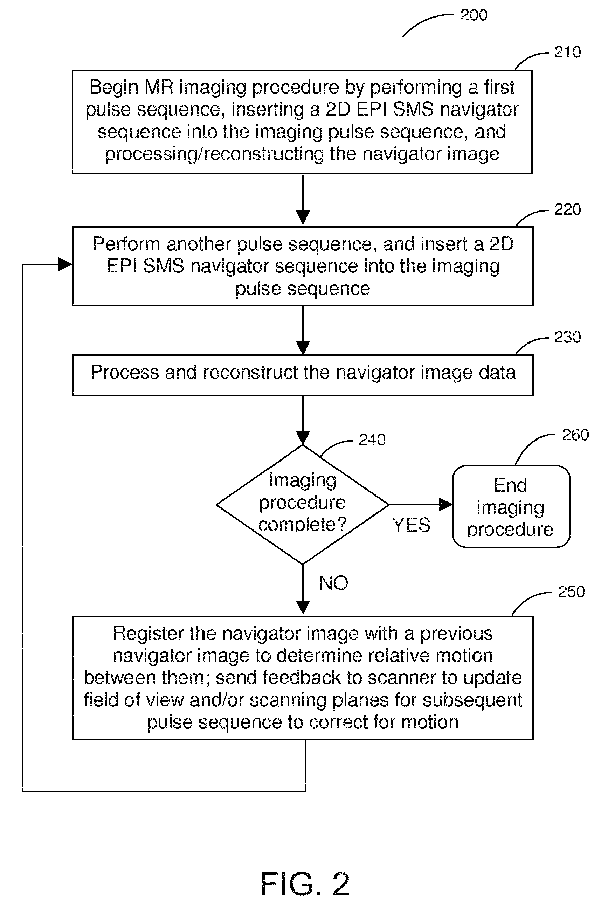

An exemplary method for obtaining prospective motion-corrected MR images using fast 2D EPI SMS-based navigators, in accordance with further exemplary embodiments of the disclosure, is shown in the flowchart 200 of FIG. 2. In a first step 210 of the exemplary method, an MR imaging procedure can be initiated by performing a first pulse sequence using, e.g., the by a pulse generation unit 15 that is controlled by a pulse sequence control unit 17 of the MR imaging system 1 shown in FIG. 1. A 2D EPI SMS navigator sequence can be inserted into the imaging pulse sequence using, for example, the pulse generation unit 15 and pulse sequence control unit 17, to obtain navigator image data. The navigator image data can be processed and reconstructed, e.g., using the image processing unit 31, to obtain a navigator image.

The next step 220 includes performing a next pulse sequence for the imaging procedure and inserting another 2D EPI SMS navigator sequence into this pulse sequence. This navigator image data can also be processed and reconstructed in step 230 to obtain a next navigator image. The processing/reconstruction of the navigator image can be performed, e.g., during the pulse sequence.

The next step 240 includes determining whether the imaging procedure is complete. If it is, then the imaging procedure is ended in step 260, and the image data obtained can be processed and reconstructed as desired. If the imaging procedure is not complete, then in step 250 the navigator image can be registered with a previous navigator image, e.g., using the image processing unit 31 and/or processor arrangement 37, to determine any relative motion of the subject that has occurred between obtaining the image data for the previous navigator and for the present navigator. Feedback information can then be provided to the pulse generation unit 15 and/or to other components of the magnetic resonance system 1 to update the field of view and/or scanning planes for the subsequent pulse sequence. Such feedback information can thus be used to adjust imaging parameters for the subsequent pulse sequence to correct the data acquisition for detected motion of the subject between pulse sequences.

After the motion-correction feedback information is provided, another pulse sequence for the imaging procedure with an inserted 2D EPI SMS navigator sequence can be performed in step 220, where this next pulse sequence is based on the motion-correction feedback information. Steps 220-250 can be repeated until the imaging procedure is ended in step 260.

The method 200 can be performed using the exemplary system 100 shown in FIG. 1, where components of the system 1 are configured to provide the particular navigator sequences and processing/reconstruction/registration/feedback steps described herein to facilitate prospective motion correction during the imaging procedure. Various parameters and features described herein can be used in the disclosed method according to further embodiments of the disclosure.

Accordingly, as described herein and illustrated by the examples below, embodiments of the present disclosure can provide very fast navigator-based prospective motion correction during MR imaging procedures. Such navigators can be obtained using simultaneous multi-slice (SMS) techniques with blipped-CAIPI phase shifting between simultaneously-acquired slices to avoid blurring artifacts and undesirable "tilted voxel" effects. The combination of certain spatial resolutions, FOV values, and shot/SMS parameters as described herein facilitate acquisition of navigator image data in very short times, where such navigators also provide sufficient spatial information to accurately detect motion of a subject between pulse sequences in an MR imaging procedure. The prospective motion correction system and method described herein also does not require additional hardware such as, e.g., external marker affixed to a subject during the imaging procedure.

### Example 1

To demonstrate the accuracy of the prospective motion correction system and method described herein, 2D SMS EPI navigator images were acquired of two human subjects. Each subject was asked to move their head to twelve distinct positions and orientations (relative to a particular initial location) during the imaging procedure. The images were obtained using a 3T MAGNETOM® Skyra scanner (Siemens Healthcare GmbH, Erlangen, Germany). The following parameters were used to image these navigators: FOV: 256x256x80 mm³; spatial resolution: 8x8x8 mm³(for a voxel matrix size of 32x32x10, e.g., 10 slices of 8 mm thickness); a flip angle of 10°; two-shot SMS with 5 slices excited simultaneously per shot (SMS-5); and a relative shift between slices of FOV/4 for the blipped-CAIPI technique.

The acquisition time for each slice group consisting of 5 slices was 14 msec, leading to a total acquisition time of 28 ms for the entire navigator volume (two shots of 5 slices each).

For comparison, the same subjects were also imaged in the same twelve positions/orientations using a conventional high spatial resolution (1 mm³) 3D fast low angle shot (3D FLASH) MR imaging technique (a gradient echo (GRE) technique), using the 3T MAGNETOM® Skyra scanner. The scan time for the 3D FLASH scan was approximately two minutes per position. The imaged navigator volumes were then co-registered and motion estimates were derived from the images for each of these two imaging techniques.

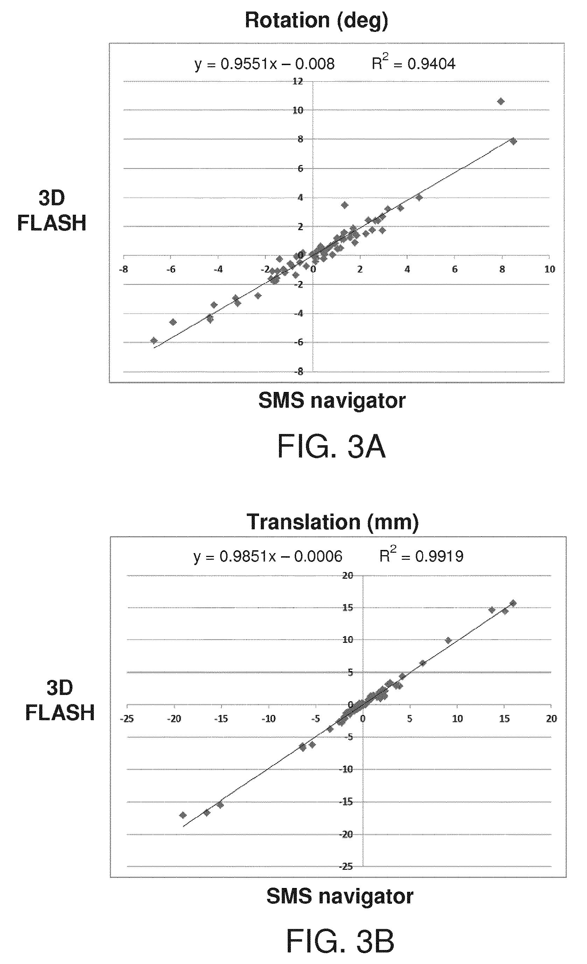

Motion estimates (rotation and translation) for the subject images are shown in FIGS. 3A and 3B, respectively, for both the 2D SMS EPI navigator technique and the high-resolution 3D FLASH technique. Rotational motion estimates derived from the SMS navigator images (having an 8 mm³ resolution) show excellent correlation with those derived from the 3D FLASH images (having 1 mm³ resolution), as shown in FIG. 3A. All of the data points in FIG. 3A lie substantially on a 45-degree line, indicating that both techniques yield the same rotational motion estimates.

Similarly, translational motion estimates for the subject images are shown in FIG. 3B for the 2D SMS EPI navigator technique and the high-resolution 3D FLASH technique. Again, translational motion estimates derived from these two sets of images exhibit an excellent correlation. These results indicate that the lower-resolution and much faster 2D SMS EPI navigator system and method, in accordance with embodiments of the present disclosure, yield the same rotational and translational motion estimates as the higher-resolution 3D FLASH technique that requires substantially longer acquisition times.

### Example 2

To provide an indication of the range of motion identifiable with the prospective motion correction system and method described herein during MR imaging, five healthy volunteers were scanned with a 2.5-minute long SMS navigator sequence during which the five subjects were instructed to freely move their heads. The navigator parameters were the same for those used in Example 1 above, i.e.: navigator image data was obtained using a 3T MAGNETOM® Skyra scanner (Siemens Healthcare GmbH, Erlangen, Germany); FOV: 256x256x80 mm³; spatial resolution: 8x8x8 mm³ (voxel matrix size of 32x32x10, with 10 slices of 8 mm thickness); a flip angle of 10°; two-shot SMS with 5 slices excited simultaneously per shot (SMS5); and a relative shift between slices of FOV/4 for the blipped-CAIPI technique.

The navigator images were retrospectively registered to derive a range of motion estimates within which SMS navigators are expected to function accurately. The range of motion derived from the navigator images are as follows:

| | | |
|---|---|---|
| Rotation (degrees): | X-axis: | -8.6 to 5.4 |
| | Y-axis: | -8.4 to 8.0 |
| | Z-axis: | -6.7 to 8.5 |

| | | |
|---|---|---|
| Translation (mm): | X-axis: | --19.0 to 16.0 |
| | Y-axis: | -11.4 to 4.3 |
| | Z-axis: | -16.5 to 15.0 |

These results indicate that, although the slice GRAPPA reconstruction of the navigator image data indirectly uses spatially-dependent coil sensitivity information to separate the slices, good reconstruction fidelity was observed over a range of head positions in all five subjects. Accordingly, the system and method described herein is capable of prospectively detecting subject motion during an MR imaging procedure over a range of motion (translational and rotational) that may typically be encountered in clinical settings.

### Example 3

To demonstrate the efficacy of the prospective motion correction system and method described herein for an MR imaging procedure, two subjects were imaged with a conventional magnetization-prepared rapid acquisition gradient echo (MPRAGE) sequence using a 3T MAGNETOM® Skyra scanner (Siemens Healthcare GmbH, Erlangen, Germany) with a 32 channel receive coil. Parameters for the MPRAGE scan were: spatial resolution: 1x1x1 mm³ ; GRAPPA acceleration factor: 3; total scan time: 4 minutes.

2D SMS EPI navigators in accordance with embodiments of the present disclosure were inserted into the TI gaps of the MPRAGE sequences. The following parameters were used for the navigators obtained during the MPRAGE sequences: FOV: 256x256x80 mm³; spatial resolution: 8x8x8 mm³ (voxel matrix size of 32x32x10); a flip angle of 10°; two-shot SMS with 5 slices excited simultaneously per shot (SMS-5); and a relative shift between slices of FOV/4 for the blipped-CAIPI technique.

During each TR a low resolution volume was created from the EPI navigator slices and used for prospective motion correction based on the 3DPACE technique. The entire navigator processing and reconstruction procedure, including obtaining the navigator image data, slice GRAPPA-based unaliasing, registration of navigators to prior navigators using a 3D PACE technique, providing feedback to the scanner apparatus based on detected motion of the subject, and field-of-view update for the subsequent sequence, was completed in ∼ 100 ms.

To evaluate the efficacy of motion correction, the two healthy subjects were scanned with a motion-corrected MPRAGE procedure using the fast EPI SMS navigators and with a conventional non-motion-corrected MPRAGE sequence. The two subjects were deliberately instructed to follow a predefined motion protocol during both scans.

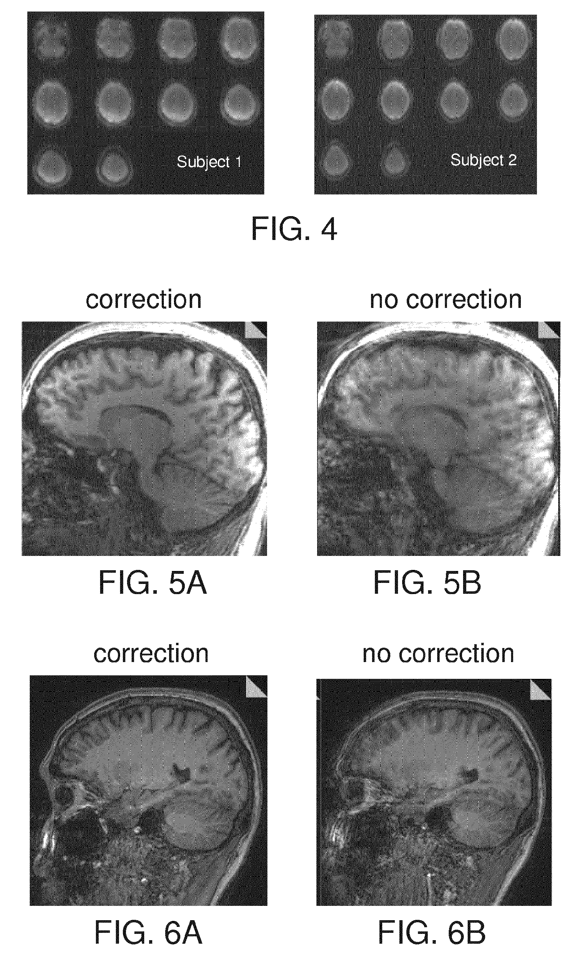

Fig. 4 shows sample EPI navigator images acquired in the two subjects using the exemplary 2D EPI SMS-5 procedure described herein. In spite of the high SMS acceleration (5 slices acquired simultaneously for each shot), good image quality is obtained without any evident residual slice leakage.

The MPRAGE imaging scan results for the first subject with and without prospective motion correction are shown in FIGS. 5A and 5B, respectively. The maximum detected rotation and translation values were 6.3 deg and 4.2 mm for the motion-corrected imaging procedure, and 6.0 deg, 3.4 mm for the imaging procedure with no motion correction. These detected motion ranges are comparable for both procedures. However, the scan with prospective motion correction shown in FIG. 5A exhibits significantly improved image quality as compared to the uncorrected image shown in FIG. 5B. The MPRAGE imaging scan results for the second subject with and without prospective motion correction are shown in FIGS. 6A and 6B, respectively. Again, the motion-corrected scan in FIG. 6A using fast 2D EPI SMS navigators, in accordance with embodiments of the present disclosure, shows vastly improved image quality as compared to the uncorrected image shown in FIG. 6B.

The foregoing merely illustrates the principles of the present disclosure. Various modifications and alterations to the described embodiments will be apparent to those skilled in the art in view of the teachings herein. It will thus be appreciated that those skilled in the art will be able to devise numerous techniques which, although not explicitly described herein, embody the principles of the present disclosure and are thus within the spirit and scope of the present disclosure. All patents and publications cited herein are incorporated herein by reference in their entireties.

## Claims

1. A magnetic resonance (MR) imaging system for generating a real-time motion-corrected MR image of a region of interest, comprising:
a pulse sequence generator configured to insert a navigator sequence into each of a plurality of MR imaging sequences used to obtain the MR image to obtain navigator image data;
an image processor arrangement configured to reconstruct a navigator image based on the navigator data; and
a processing arrangement configured to determine motion of the region of interest by comparing the navigator image with a previous navigator image, and to modify a subsequent imaging sequence based on the determined motion,
wherein the navigator image data is obtained using a 2D echo-planar imaging technique comprising between 1 and 10 shots;
wherein each shot is configured to simultaneously excite between 2 and 12 slices of the navigator image;
wherein a field of view of the navigator image is between 100 mm and 500 mm in each direction within each slice of the navigator image and between 20 mm and 500 mm in a direction perpendicular to the navigator slices; and
wherein a spatial resolution for the navigator image in each direction is between 3 mm and 10 mm; and
wherein a total time for obtaining the navigator image data is less than 100 ms.

2. The MR imaging system of claim 1, wherein the navigator image data is obtained using a blipped-CAIPI technique, and wherein an image shift between slices in the phase encoding direction is between FOV/2 and FOV/7.

3. The MR imaging system of claim 1, wherein the navigator image data is obtained using a 2D echo-planar imaging technique comprising between 1 and 6 shots

4. The MR imaging system of claim 1, wherein the navigator image data is obtained using a 2D echo-planar imaging technique comprising between 2 and 4 shots

5. The MR imaging system of claim 1, wherein the field of view is between 200 mm and 300 mm in each direction within each slice of the navigator image.

6. The MR imaging system of claim 1, wherein a field of view is between 50 mm and 150 mm in a direction perpendicular to the navigator slices.

7. The MR imaging system of claim 1, wherein the spatial resolution for the navigator image in each direction is between 5 mm and 8 mm.

8. The MR imaging system of claim 1, wherein a flip angle used for the 2D echo-planar imaging technique is between 2 degrees and 40 degrees.

9. The MR imaging system of claim 1, wherein a flip angle used for the 2D echo-planar imaging technique is between 5 degrees and 20 degrees.

10. The MR imaging system of claim 1, wherein a total acquisition time for the navigator image data is less than 100 ms.

11. The MR imaging system of claim 1, wherein a total acquisition time for the navigator image data is less than 50 ms.

12. The system of claim 1, wherein the imaging sequence comprises at least one of a T1-weighted spin echo sequence, a T2-weighted spin echo sequence, a FLAIR sequence, a proton density-weighted spin echo sequence, a turbo spin echo sequence, a gradient echo sequence, a functional imaging sequence, a diffusion image sequence, a contrast enhanced perfusion sequence, a non-contrast perfusion sequence, and a blood oxygenation level dependent sequence.

13. A method for generating a real-time motion-corrected magnetic resonance (MR) image of a region of interest, comprising the steps of:
(a) providing a plurality of pulse sequences to obtain image data from the region of interest that can be used to generate the MR image;
(c) inserting a 2D multi-slice EPI navigator sequence within each of the plurality of pulse sequences;
(d) generating a navigator image of a portion of the region of interest based on the navigator sequence;
(e) determining a motion of the region of interest based on a comparison of the navigator image with a previous navigator image;
(f) modifying properties of a subsequent pulse sequence based on the determined motion to correct for motion effects; and
(h) generating the motion-corrected MR image of the region of interest based on the image data,
wherein the navigator image is obtained using a 2D echo-planar imaging technique comprising between 1 and 10 shots;
wherein each shot is configured to simultaneously excite between 2 and 12 slices of the navigator image;
wherein a field of view is between 100 and 500 mm in each direction within each slice of the navigator image and between 20 and 500 mm in a direction perpendicular to the navigator slices; and
wherein a spatial resolution for the navigator image in each direction is between 3 mm and 10 mm; and
wherein a total time for obtaining the navigator image data is less than 100 ms.

14. The method of claim 13, wherein each of the plurality of pulse sequences comprises at least one of a T1-weighted spin echo sequence, a T2-weighted spin echo sequence, a FLAIR sequence, a proton density-weighted spin echo sequence, a turbo spin echo sequence, a gradient echo sequence, a functional imaging sequence, a diffusion image sequence, a contrast enhanced perfusion sequence, a non-contrast perfusion sequence, and a blood oxygenation level dependent sequence.

15. The method of claim 13, wherein the navigator image data is obtained using a blipped-CAIPI technique, and wherein an image shift between slices in the phase encoding direction is between FOV/2 and FOV/7.

16. The method of claim 13, wherein the navigator image data is obtained using a 2D echo-planar imaging technique comprising between 1 and 6 shots

17. The method of claim 13, wherein the field of view is between 200 mm and 300 mm in each direction within each slice of the navigator image, and wherein the field of view is between 50 mm and 150 mm in the direction perpendicular to the navigator slices.

18. The method of claim 13, wherein the spatial resolution for the navigator image in each direction is between 5 mm and 8 mm.

19. The method of claim 13, wherein a flip angle used for the 2D echo-planar imaging technique is between 2 degrees and 40 degrees.

20. The method of claim 13, wherein a total acquisition time for the navigator image data is less than 100 ms.
